# EUROPEAN PATENT SPECIFICATION

(11) **EP 2 738 827 B1**
(45) Date of publication and mention of the grant of the patent: **06.04.2022**
(21) Application number: 12194922.6
(22) Date of filing: 29.11.2012
(51) Int. Cl.: H01L 49/02, H01L 23/522, H01L 23/64, H01L 23/00, H01L 27/01

(54) **MIMCAP structure in a semiconductor device package**
MIMCAP-Struktur in einem Halbleiterbauelementegehäuse
Structure MIMCAP dans un boîtier de dispositif semi-conducteur

(43) Date of publication of application: 04.06.2014
(73) Proprietor: IMEC VZW, 3001 Leuven (BE)
(72) Inventor: DETALLE, Mikael, B-3001 Leuven (BE); BEYNE, Eric, B-3001 Leuven (BE)
(74) Representative: AWA Benelux

(56) References cited:
- US-A1- 2003 211 731
- US-A1- 2004 106 266
- US-A1- 2005 095 781
- US-A1- 2005 098 815
- US-A1- 2011 062 549

## Description

### Field of the Invention

The present invention is related to semiconductor processing. The invention is in particular related to a metal-insulator-metal capacitor and its integration in the back-end-of-line (BEOL) processing of a semiconductor package.

### State of the art.

Device downscaling in present day CMOS technology is leading to faster switching speeds of the transistors integrated with a higher density on the semiconductor wafer. However, in the final device, large current spikes may occur due to a large number of 'simultaneous' switching events in the circuit within a short period of time, which can cause considerable current-resistance drop and noise over the power supply network. Voltage fluctuation and power supply noise may impact signal integrity, speed and reliability of the devices. It has been shown that the addition of an on-chip decoupling MIMCAP (Metal-Insulator-Metal capacitor) can reduce this problem and enhance circuit performance. The MIMCAP can compensate voltage fluctuations by delivering charges to the power-supply network. However, its capacitance needs to be large enough to be actually efficient. In addition, low resistance and low inductance is needed to enable the efficient application of MIMCAPs at high frequencies. In present day MIMCAP designs, resistance especially is too high for this purpose because of the connections from at least one of the metallization levels to the top and/or the bottom plate of the MIMCAP. Such connections are established by via etching and filling techniques, typically increasing the resistance of the path from said metallization layer(s) to the MIMCAP, as shown in the following citations.

US 2003/0211731 A1 discloses a method for the creation of a MIM capacitor using damascene process for creation of interconnect plugs.

US 2011/0062549 A1 discloses an integrated passive semiconductor device with a capacitor formed over and electrically connected to a semiconductor die.

### Summary of the invention

The invention is related to a MIMCAP design that does not suffer from the above-described problem. The invention is in particular related to a MIMCAP structure as disclosed in the appended claims and to a method for producing such a structure. A MIMCAP according to the invention is located between a first and second metallization layer in a stack of metallization layers, in particular copper metallization layers, obtainable by single damascene processing steps as known in the art, said stack supporting semiconductor devices, which are connected through said metallization layers to an external power source. The MIMCAP comprises a bottom plate in the first metallization layer, a first conductive layer on and in electrical contact with said bottom plate, a dielectric layer on and in contact with said first conductive layer, a second conductive layer on and in contact with said dielectric layer, and a top plate in the second metallization layer, on and in electrical contact with the second metal plate. The contacting of the bottom and top plates of the MIMCAP from the first and second metallization layer is thereby established without vias between said plates and said metallization layers. In addition, the first conductive layer of the MIMCAP may extend beyond the surface of the dielectric and the second layer for forming other structures.

In particular, the invention is related to a semiconductor device package comprising one or more semiconductor devices and an interposer substrate ; the interposer substrate comprising a metallization stack; the one or more semiconductor devices electrically coupled to the metallization stack, said metallization stack comprising a plurality of interconnected metallization layers, wherein a metal-insulator-metal capacitor is formed between two of said metallization layers, a lower layer and an upper layer, said layers being directly adjacent in the stack, said capacitor comprising :
- At least a portion of a bottom plate which is part of the lower metallization layer,
- At least a portion of a first conductive layer on and in contact with said bottom plate,
- A dielectric layer on and in contact with said first conductive layer,
- A second conductive layer on and in contact with said dielectric layer,
- A top plate which is a first part of the upper metallization layer, said top plate being on and in contact with said second conductive layer and extending vertically from the second conductive layer to a top surface level of the upper metallization layer, wherein the first conductive layer extends beyond the surface of the dielectric layer and the second conductive layer thus forming an extension portion laterally extending beyond an area covered by the dielectric layer and the second conductive layer; and
wherein the interposer substrate further comprises a conductive via which forms a second lateral part of the upper metallization layer and is laterally separated from the first part of the upper metallization layer, the conductive via extending vertically from the extension portion of the first conductive layer to the top surface level of the upper metallization layer.

According to an embodiment, said first conductive layer may be patterned in the area outside the area covered by the MIMCAP. Said first conductive layer may be patterned to form one or more patterned portions, which serve as contact portions for electrical circuit elements in the lower or upper metallization layer and/or which serve themselves as said electrical circuit elements.

According to an embodiment, a patterned portion of the first conductive layer forms a resistor in the upper metallization layer, and wherein a stack of a dielectric layer portion and a top conductive layer portion is present on top of said resistor, said dielectric layer and top conductive layer portion being of the same material and thickness of said dielectric layer and second conductive layer of said capacitor.

According to an embodiment, the second conductive layer is surrounded in the plane of the layer by a ring structure of the same material and thickness of said second conductive layer.

Said first and second metallization layer may be the power supply layer and the ground layer respectively of the interposer substrate carrying one or more integrated circuit devices.

Said bottom and/or top plate may be provided with perforations through the complete thickness of the plates, said perforations being filled with a dielectric material.

The invention is equally related to a method for producing a semiconductor package according to the invention, comprising the steps of :
- Producing the lower metallization layer by a damascene process, said lower metallization layer comprising the bottom plate,
- Depositing a stack of the first conductive layer, the dielectric layer and the second conductive layer on and in contact with said lower metallization layer,
- Patterning at least the second layer and the dielectric layer to form a stack of the first conductive layer or a portion thereof, the dielectric layer and the second conductive layer, which covers at least partially said bottom plate,
- Producing the upper metallization layer by a damascene process, said second metallization layer comprising the top plate which is on and in contact with the second conductive layer of said stack and the conductive via.

According to another embodiment, said patterning step is performed to the effect of forming a stack of the dielectric layer and the second conductive layer on top of the first conductive layer, said first conductive layer remaining intact after said patterning step.

According to an embodiment, said first conductive layer is further patterned in a second patterning step. During said second patterning step, said first conductive layer and the second conductive layer portion of said stack may be patterned simultaneously.

During said second patterning step, the second conductive layer portion of the stack may be patterned to form a ring structure around a central portion of the second conductive layer.

### Brief description of the figures

Figures 1a to 1e illustrate the steps of the method according to one embodiment not covered by the claimed invention.
Figures 2a to 2e illustrate the method according to an embodiment of the invention.
Figures 3a to 3c illustrate the method according to a further embodiment.
Figures 4a and 4b illustrate embodiments of a device structure according to the invention.
Figures 5a and 5b illustrate embodiments of a resistor device that can be produced together with a MIMCAP according to the invention.

### Detailed description of the invention

### Definitions :

Metallization layer : one of a stack of layers of a dielectric material, with electrically conductive material forming a pattern embedded in said layer. Subsequent metallization layers in the stack are isolated from each other except through vertical connections between the electrically conductive material.
patterning step : procedure in which portions of a layer are removed by etching away said portions while the remainder of the layer is protected by an etch mask, leaving a pattern formed by the remaining parts of the layer. The patterning may take place by known photolithography techniques involving a resist layer, or by hard mask techniques, equally known in the art.

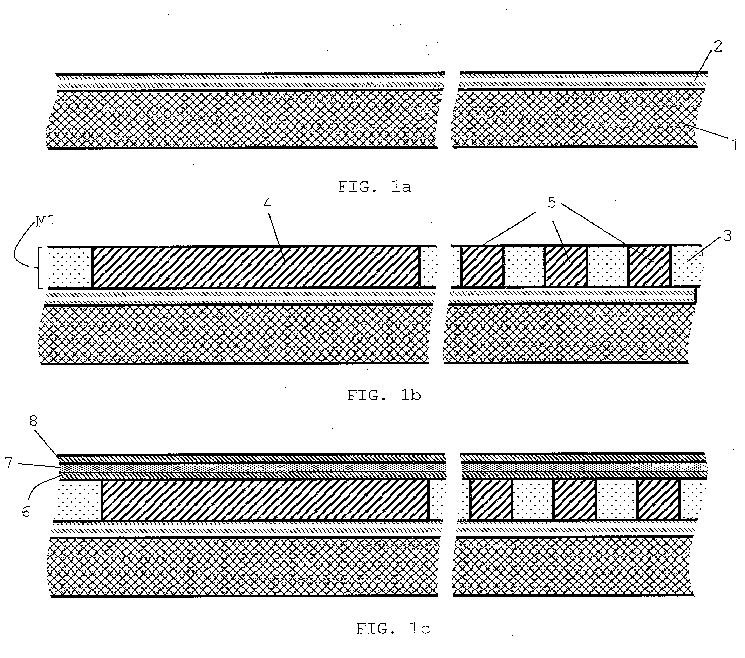

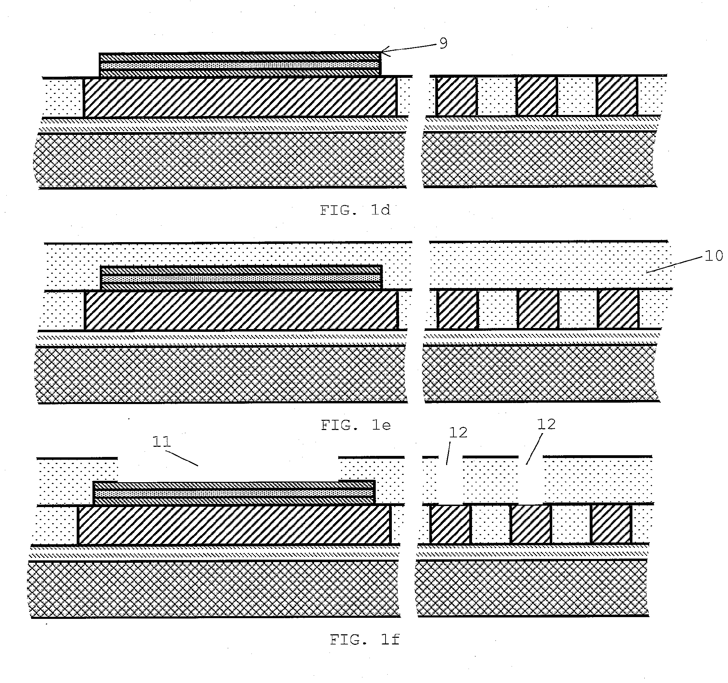

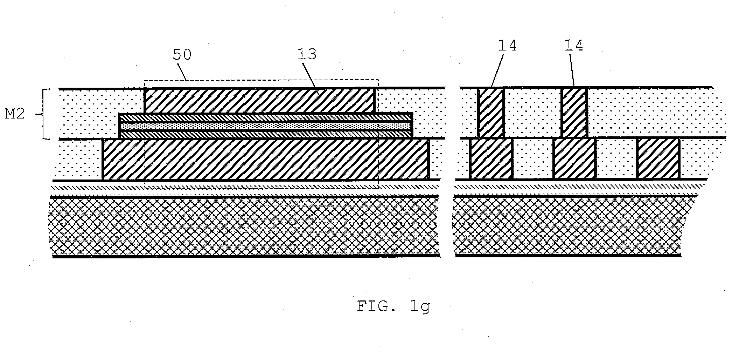

Figure 1 illustrates one embodiment for producing a MIMCAP not covered by the claimed invention, located between two copper metallization layers produced on a substrate. The substrate may for example be an active or passive interposer substrate onto which various integrated circuit chips are to be assembled. Figure 1a shows the substrate as a Silicon base substrate 1, provided with an isolation layer 2. The isolation layer 2 could be a layer consisting of silicon oxide or silicon nitride or silicon carbide or a combination (e.g. a stack) of two or three of these materials. Alternatively, the substrate may be a glass substrate (i.e. instead of the combined Si+isolation layer).

On the substrate, a first metallization layer M1 is produced by a damascene process as known per se in the art. A first layer 3 of inter-metal dielectric (IMD) is deposited, and patterned by a patterning step as defined above, to form openings and/or trenches, which are then lined with a barrier layer for preventing Cu-diffusion into the IMD combined with a copper seed deposited by a suitable deposition technique (such as physical or chemical vapour deposition - PVD or CVD) as known in the art. After that, copper is plated (using electrochemical deposition ECD) to fill openings and/or trenches. The copper which has been plated not only in the openings and trenches but also on top of the IMD, is planarized by a CMP (Chemical Mechanical Polishing) step, which leads to the result shown in figure 1b. The barrier layer is not shown in this drawing. In the method of the invention, the first metallization layer M1 thus obtained comprises at least one plate 4 which is to form the bottom plate of the MIMCAP. This may be a rectangular plate for example. The bottom plate 4 is preferably provided with perforations (not shown) filled with dielectric, which serve to maintain flatness of the bottom plate during CMP. The perforations are obtained as non-etched IMD portions during the IMD patterning step, onto which the copper is deposited, the copper filling the spaces between the IMD portions.

By way of example, three further copper structures 5 are shown, for example conductors running along a pre-defined pattern in the first metallization layer M1. Then a stack of three layers is deposited on the planarized surface (fig. 1c), for example by a PVD deposition step : a first electrically conductive layer 6, a dielectric layer 7 and a second electrically conductive layer 7. In the rest of this description and in the claims, these electrically conductive layers 6 and 8 will be referred to as 'conductive layers' for reasons of conciseness. They may be metal layers or layers of materials like TiN or TaN. The stack of layers 6/7/8 is patterned, to form the MIM-stack 9 (fig. Id), which covers at least a portion of the bottom plate 4. This is followed by the deposition of a further IMD layer 10 (fig. 1e), which is patterned to form at least one opening 11 on top of the MIM-stack, as well as vias 12 towards some of the structures 5 (fig. If). By another damascene process, the openings are filled with copper and planarized, resulting in the second metallization layer M2, comprising the top plate 13 (equally preferably perforated for maintaining flatness), in contact with the second conductive layer 8 of the MIM-stack (fig. 1g), as well as via connections 14 for connecting the structures 5 with a further metallization layer. The final MIMCAP-structure 50 consists of a portion of the bottom plate 4, first conductive layer 6, dielectric 7, second conductive layer 8 and top plate 13.

In this method, no via connections are produced towards the top or bottom plate of the MIMCAP. The MIMCAP as such is characterized by the presence of a bottom plate 4, first conductive layer 6 in contact with the bottom plate 4, dielectric layer 7 in contact with the first conductive layer 6, second conductive layer 8 in contact with the dielectric layer 7, and top plate 13 in contact with the second conductive layer, wherein the bottom plate is part of a first metallization layer and the top plate is part of a second metallization layer in a metallization stack coupled between one or more semiconductor devices and an external power source.

According to a specific embodiment, the formation of the MIM-stack 9 takes place by multiple patterning steps, wherein in the first patterning step, the first conductive layer 6 remains intact on the surface of the planarized first metallization layer M1, while the dielectric 7 and the second conductive layer 8 are patterned to form a stack of these two layers covering at least a portion of the bottom plate 4. After that, a second patterning step is performed to pattern the first conductive layer 6 and possibly the second conductive layer 8 simultaneously. In this way, the first conductive layer can be used to form additional structures within the first metallization layer M1.

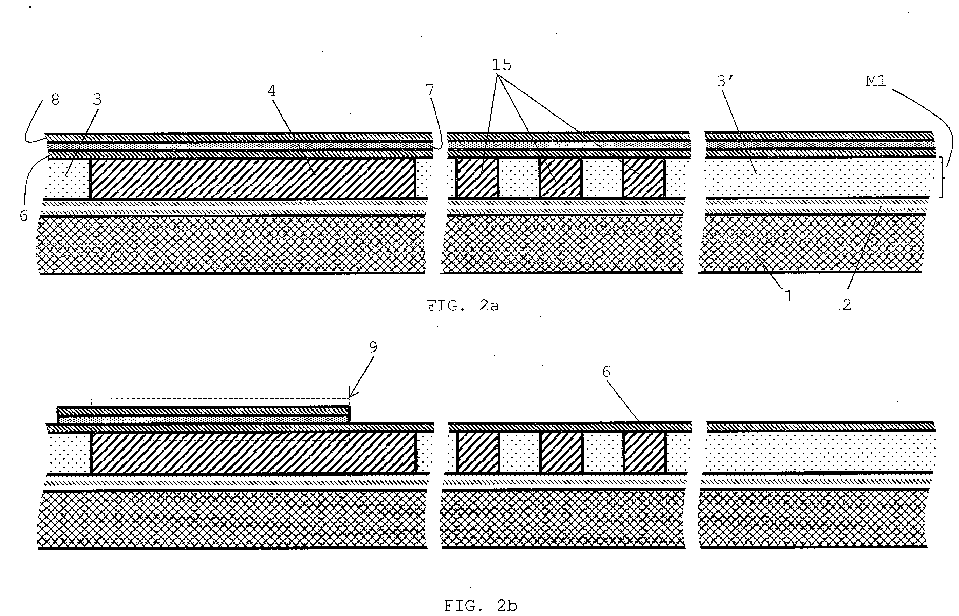

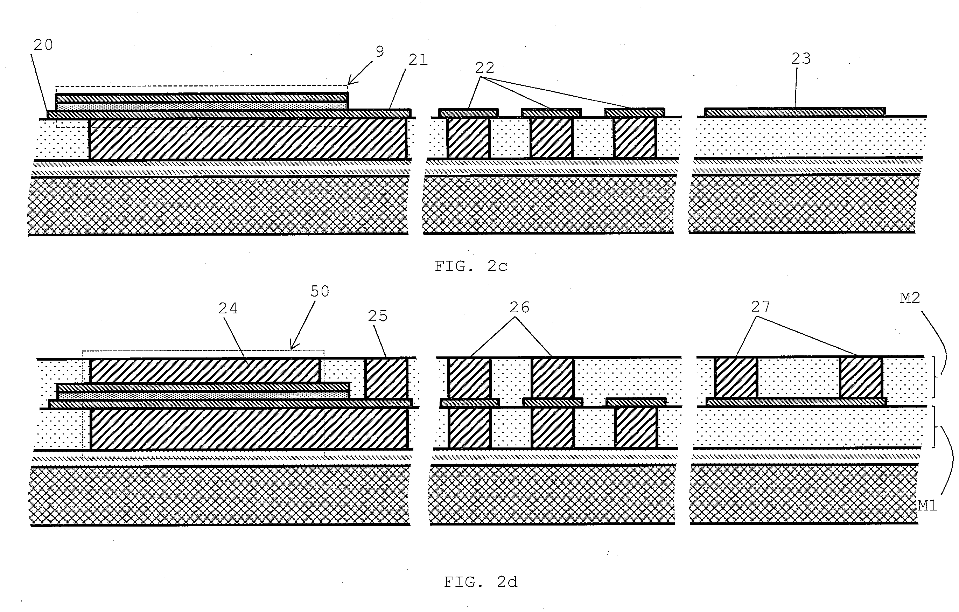

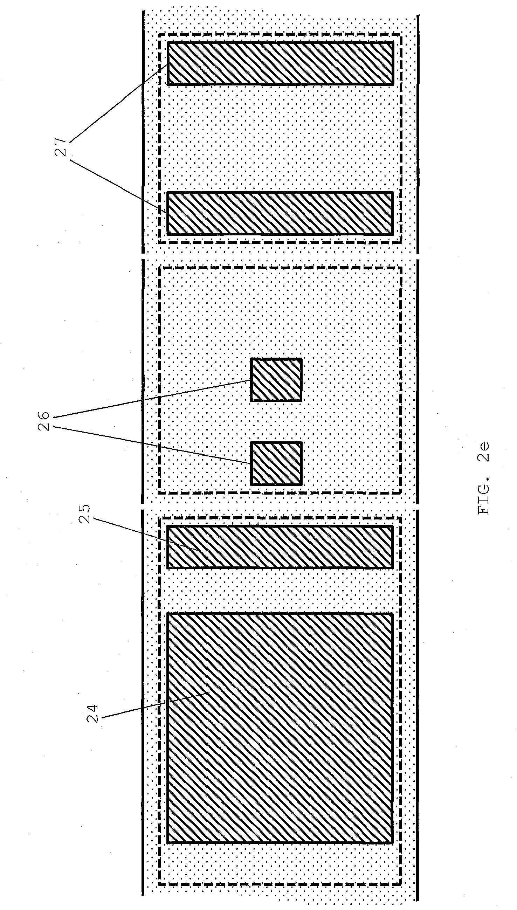

This embodiment is illustrated in figure 2. Figure 2a shows the stage where the stack of layers 6/7/8 described in relation to figure 1, has been deposited on the planarized first metallization layer M1. The structures 15 are part of an inductor pattern in the first metallization layer M1, while the MIM-stack also extends over a portion 3' of the IMD 3 of M1, with no metal present in said portion. Figure 2b shows the result of a first patterning step wherein only the dielectric layer 7 and the second conductive layer 8 are patterned to form a MIM-stack 9 which covers at least a portion of the bottom plate 4. The MIM-stack 9 consists of the remainder of the dielectric layer 7 and second conductive layer 8, and of a portion of the first conductive layer 6, said conductive layer being still intact on the whole surface of the first metallization layer M1. The etching of layers 7 and 8 stops on the first conductive layer 6 (possible by suitable choice of etchant in relation to the material of the first conductive layer 6).

In a second patterning step, the first conductive layer 6 is patterned, as shown in figure 2c. Portions 20 and 21 of said layer 6 to the left and right of the MIM stack remain. Furthermore, a portion 22 above the inductor structure 15 and covering the entire inductor structure remains as well. Finally, a rectangular portion 23 remains on the portion 10' of the IMD. These portions 20 to 23 of the first conductive layer 6 can now serve as additional structural elements in the metallization layout. Deposition and patterning of the second metallization layer M2 results in the view of figure 2d, once again with the top copper plate 24 on and in contact with the second conductive layer 8 of the MIM-stack. A via 25 is produced for contacting the first conductive layer 6 and thus the bottom plate 4 from the second metallization layer M2. Vias 26 are provided for contacting the inductor 15, while rectangular vias 27, as seen in the top view of figure 2e, are produced for connecting the rectangular portion 23 of the first conductive layer to the second metallization layer M2. In this way, said rectangular portion 23 may be integrated as a resistor in the circuit defined within said second metallization layer M2.

The function of the inductor shaped portion 22 of layer 6 and of the portion 21 to the right of the MIMCAP (contacted by via 25) is to provide an advantage in the processing of the M1 and M2 layers : when etching the vias 25 and 26 for example, the etching stops on the first conductive layer 6 (e.g. a TaN layer), and not on the Cu. Stopping on a Cu layer leads to contamination of the etching chamber, which complicates the process. The presence of the first conductive layer 6 makes it possible to avoid those complications (by patterning the portion 22) at least during processing of the M1 and M2 layers, which is particularly advantageous given the high copper density of the layers M1 and M2. So even though the invention is not limited (as seen in figure 1 for example) to the embodiment wherein portions of the first conductive layer 6 remain on inductors and/or other structures in the M1 level, the invention does represent a considerable advantage in providing this possibility.

In the case of the inductor 15, it is not excluded that the patterned portion 22 of layer 6 plays itself the part of an inductor (i.e. without the inductor pattern 15 in the M1 level), although the thickness of the inductor pattern 22 would be insufficient for serving as a workable inductor in many practical circumstances in terms of the material and thickness of the metallization layers and the MIM-stack layers. In general, it can be said that the patterned portions of the first conductive layer 6 may serve as contact portions for structures (such as inductor 15) in one of the metallization layers M1/M2 or said portions may themselves play the part of circuit elements in said metallization layers (such as the resistor 23, or theoretically, the inductor pattern 22).

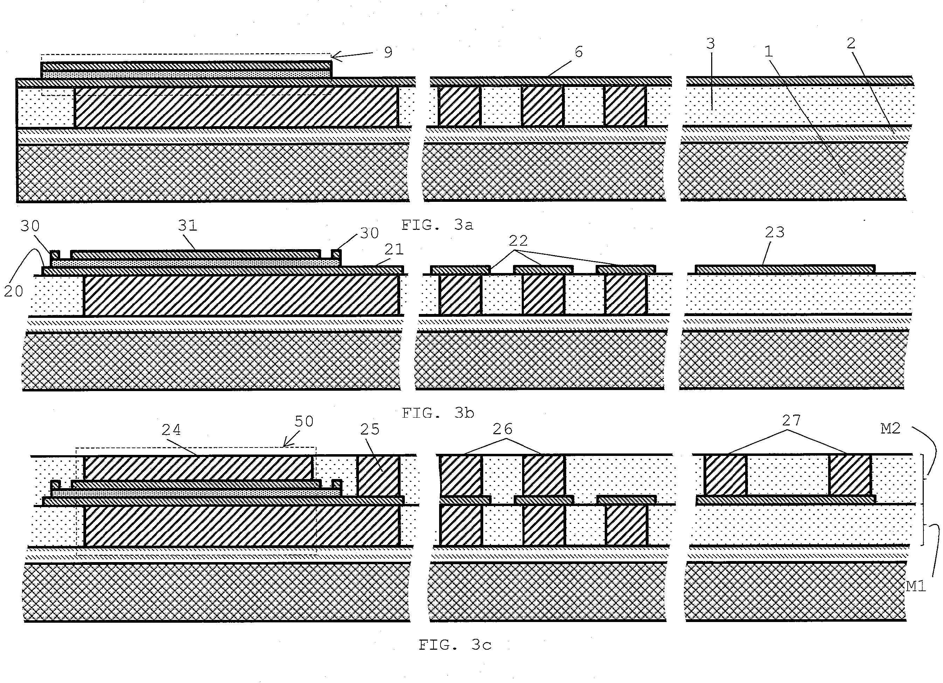

In a still further embodiment, the patterning step executed for patterning the first conductive layer 6 serves also to pattern the portion of the second conductive layer 8 that forms the top layer of the MIM stack 9. According to a preferred embodiment illustrated in figure 3, this patterning is to the effect that a ring structure 30 (not necessarily circular-shaped) is formed surrounding a central portion 31 of said top conductive layer 8, in the plane of the MIMCAP. The top copper plate 24 then only contacts the central portion 31. The ring portion 30 serves to prevent possible shorting between the top and bottom electrodes at the edge of the capacitor. The structure of the MIMCAP of the invention, and its production method allow to produce such a protective ring 30 simultaneously with the patterning of the first conductive layer 6, and thus provides an economic way of producing complex structures.

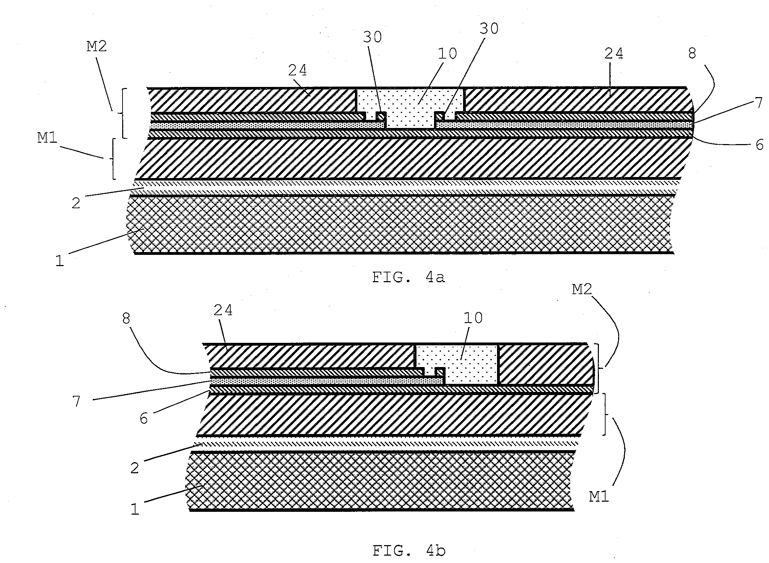

According to another embodiment, the first conductive layer 6 remains intact after a first patterning step, as in the embodiments of figures 2 and 3, but in the second patterning step, it is only the second conductive layer 8 which is further patterned, for example to form a ring structure 30, while the first conductive layer 6 still remains intact. This final structure is illustrated in figures 4a and 4b. In these embodiments, there is no separate step of processing a separate bottom plate having dimensions that are in the same order of magnitude as the top plate 13 or 24. The bottom plate of the MIMCAP is a portion of a larger metal layer in the M1-level.

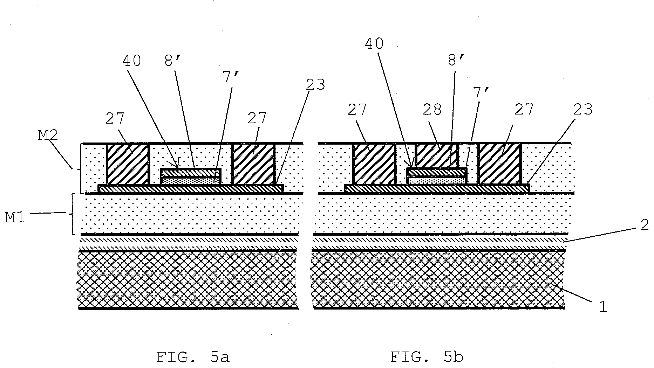

According to an embodiment, the step of patterning the dielectric layer 7 and the second conductive layer 8 of the MIM-stack, with the first conductive layer 6 remaining intact, does not only take place at the location of the eventual MIMCAP above the bottom plate 4, but a stack of portions 7' and 8' of these layers 7 and 8 may also remain on other locations. In the embodiments of figure 5a and 5b, an additional stack 40 of these portions 7' and 8' is produced on the resistor portion 23. This stack 40 provides a protection of a large portion of the resistor metal during the etching of the dielectric 7 in other areas. This therefore allows a better control of the resistance value of the resistor. The stack 40 may be further provided with a connection 28 to the next metallization layer (figure 5b).

The IMD material may be silicon oxide (SiO₂) or a combination of SiO₂ with silicon nitride (Si₃N₄) or a combination of SiO₂ with silicon carbide (SiC). The IMD may also be a low-k material. The metallization metal used in preferably copper. The thickness of the M1 and M2 levels may be according to known practice in the domain of damascene processing, e.g. around 1micron. The thickness of the M2 layer may be chosen higher than M1 given that the CMP step will generally take longer as the topography caused by the MIM-stack patterning needs to be removed.

The first and second conductive layer 6/8 of the MIM-stack may be for example Ta, TaN, Ti or TiN, but other suitable materials may be applicable. The layers 6, 7 and 8 preferably have the same thickness, e.g. between 50nm and 100nm. At least the thickness of the first and second conductive layer 6 and 8 is preferably the same, especially in the embodiment of figure 2, where both layers are etched in the same etching step.

The dielectric layer 7 of the MIM-stack may be for example SiO₂, silicon nitride (Si₃N₄), silicon carbide, Ta₂O₅, hafnium oxide, TiO₂, an ONO-stack (Oxide-nitride-oxide), or any other suitable material.

According to an embodiment, an annealing step can be performed prior to the CMP done on the first metallization layer M1. The annealing temperature is preferably between 350°C and 450°C. The annealing is done to decrease hillocks formation due to stress induced by the subsequent steps (MIM-stack deposition).

The invention can be integrated in existing BEOL process schemes. According to a preferred embodiment, the MIMCAP of the invention is integrated in an interposer substrate, in particular between the power supply layer the ground layer of such an interposer. This is particularly advantageous due to the large surface that is available for the MIMCAP.

While the invention has been illustrated and described in detail in the drawings and foregoing description, such illustration and description are to be considered illustrative or exemplary and not restrictive. Other variations to the disclosed embodiments can be understood and effected by those skilled in the art in practicing the claimed invention, from a study of the drawings, the disclosure and the appended claims. In the claims, the word "comprising" does not exclude other elements or steps, and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope.

The foregoing description details certain embodiments of the invention. It will be appreciated, however, that no matter how detailed the foregoing appears in text, the invention may be practiced in many ways, and is therefore not limited to the embodiments disclosed, the scope of protection sought being defined solely by the appended claims. It should be noted that the use of particular terminology when describing certain features or aspects of the invention should not be taken to imply that the terminology is being re-defined herein to be restricted to include any specific characteristics of the features or aspects of the invention with which that terminology is associated.

Unless specifically specified, the description of a layer being deposited or produced 'on' another layer or substrate, includes the options of
- said layer being produced or deposited directly on, i.e. in contact with, said other layer or substrate, and
- said layer being produced on one or a stack of intermediate layers between said layer and said other layer or substrate.

## Claims

1. A semiconductor device package comprising one or more semiconductor devices and an interposer substrate ; the interposer substrate comprising a metallization stack; the one or more semiconductor devices electrically coupled to the metallization stack, said metallization stack comprising a plurality of interconnected metallization layers, wherein a metal-insulator-metal capacitor (50) is formed between two of said metallization layers, a lower layer (M1) and an upper layer (M2), said layers being directly adjacent in the metallization stack, wherein said capacitor
comprises :
• At least a portion of a bottom plate (4) which is part of the lower metallization layer (M1),
• At least a portion of a first conductive layer (6) on and in contact with said bottom plate,
• A dielectric layer (7) on and in contact with said first conductive layer,
• A second conductive layer (8,31) on and in contact with said dielectric layer,
• A top plate (24) which is a first part of the upper metallization layer, said top plate being on and in contact with said second conductive layer (8) and extending vertically from the second conductive layer to a top surface level of the upper metallization layer,
wherein the first conductive layer (6) extends beyond the surface of the dielectric layer (7) and the second conductive layer (8), thus forming an extension portion (21) laterally extending beyond an area covered by the dielectric layer and the second conductive layer; and wherein the metallization stack further comprises a conductive via (25) which forms a second part of the upper metallization layer and is laterally separated from the first part (24) of the upper metallization layer, the conductive via (25) extending vertically from the extension portion (21) of the first conductive layer to the top surface level of the upper metallization layer.

2. Semiconductor package according to claim 1, wherein said first conductive layer (6) is patterned in the area outside the area covered by the MIMCAP (50).

3. Semiconductor package according to claim 1, wherein said first conductive layer (6) is patterned to form one or more patterned portions (22,23), which serve as contact portions for electrical circuit elements (15) in the lower or upper metallization layer (M1,M2) and/or which serve themselves as said electrical circuit elements.

4. Semiconductor package according to claim 3, wherein a patterned portion (23) of the first conductive layer (6) forms a resistor in the upper metallization layer (M2), and wherein a stack of a dielectric layer portion (7') and a top conductive layer portion (8') is present on top of said resistor, said dielectric layer (7') and top conductive layer portion (8') being of the same material and thickness of said dielectric layer (7) and second conductive layer (8) of said capacitor (50).

5. Semiconductor package according to any one of claims 1 to 4, wherein the second conductive layer (31) is surrounded in the plane of the layer by a ring structure (30) of the same material and thickness of said second conductive layer (31).

6. Semiconductor package according to any one of claims 1 to 5, wherein said first and second metallization layer (M1, M2) are the power supply layer and the ground layer respectively of the interposer substrate carrying one or more integrated circuit devices.

7. Semiconductor package according to any one of claims 1 to 6, wherein said bottom and/or top plate are provided with perforations through the complete thickness of the plates, said perforations being filled with a dielectric material.

8. A method for producing a semiconductor package according to any one of claims 1 to 7, comprising the steps of :
• Producing the lower metallization layer (M1) by a damascene process, said lower metallization layer comprising the bottom plate (4),
• Depositing a stack of the first conductive layer (6), the dielectric layer (7) and the second conductive layer (8) on and in contact with said lower metallization layer (M1) ,
• Patterning at least the second layer (8) and the dielectric layer (7) to form a stack (9) of the first conductive layer (6) or a portion thereof, the dielectric layer (7) and the second conductive layer (8), which covers at least partially said bottom plate (4),
• Producing the upper metallization layer (M2) by a damascene process, said second metallization layer comprising the top plate (24) which is on and in contact with the second conductive layer (8) of said stack (9) and the conductive via (25).

9. Method according to claim 8, wherein said patterning step is performed to the effect of forming a stack of the dielectric layer (7) and the second conductive layer (8) on top of the first conductive layer, said first conductive layer (6) remaining intact after said patterning step.

10. Method according to claim 9, wherein said first conductive layer (6) is further patterned in a second patterning step.

11. Method according to claim 10, wherein during said second patterning step, said first conductive layer (6) and the second conductive layer portion (8) of said stack (9) are patterned simultaneously.

12. Method according to claim 10, wherein during said second patterning step, the second conductive layer portion (8) of the stack (9) is patterned to form a ring structure (30) around a central portion (31) of the second conductive layer.

## Patentansprüche

1. Ein Halbleiterbauelementegehäuse, umfassend ein oder mehrere Halbleiterbauelemente und ein Interposer-Substrat; wobei das Interposer-Substrat einen Metallisierungsstapel umfasst; wobei das eine oder die mehreren Halbleiterbauelemente elektrisch mit dem Metallisierungsstapel gekoppelt sind, wobei der besagten Metallisierungsstapel eine Vielzahl von miteinander verbundenen Metallisierungsschichten umfasst, wobei ein Metall-Isolator-Metall-Kondensator (50) zwischen zwei der besagten Metallisierungsschichten, einer unteren Schicht (M1) und einer oberen Schicht (M2), gebildet wird, wobei die besagten Schichten direkt benachbart im Metallisierungsstapel sind, wobei der besagten Kondensator Folgendes umfasst:
- mindestens einen Abschnitt einer Bodenplatte (4), der Teil der unteren Metallisierungsschicht (M1) ist,
- mindestens einen Abschnitt einer ersten leitenden Schicht (6) auf und in Kontakt mit der besagten Bodenplatte,
- eine dielektrische Schicht (7) auf und in Kontakt mit der besagten ersten leitenden Schicht,
- eine zweite leitende Schicht (8, 31) auf und in Kontakt mit der dielektrischen Schicht,
- eine obere Platte (24), die ein erster Teil der oberen Metallisierungsschicht ist, wobei die besagte obere Platte auf und in Kontakt mit der besagten zweiten leitenden Schicht (8) ist und sich vertikal von der zweiten leitenden Schicht zu einer oberen Oberflächenebene der oberen Metallisierungsschicht erstreckt,
wobei sich die erste leitende Schicht (6) über die Fläche der dielektrischen Schicht (7) und der zweiten leitenden Schicht (8) hinaus erstreckt, wodurch ein Erweiterungsabschnitt (21) gebildet wird, der sich seitlich über einen Bereich hinaus erstreckt, der von der dielektrischen Schicht und der zweiten leitenden Schicht abgedeckt ist; und wobei der Metallisierungsstapel ferner einen leitenden Weg (25) umfasst, der einen zweiten Teil der oberen Metallisierungsschicht bildet und seitlich vom ersten Teil (24) der oberen Metallisierungsschicht getrennt ist, wobei sich der leitende Weg (25) vertikal vom Erweiterungsabschnitt (21) der ersten leitenden Schicht zur oberen Oberflächenebene der oberen Metallisierungsschicht erstreckt.

2. Halbleitergehäuse nach Anspruch 1, wobei die besagte erste leitende Schicht (6) im Bereich außerhalb des Bereichs, der von der MIMCAP (50) abgedeckt ist, gemustert ist.

3. Halbleitergehäuse nach Anspruch 1, wobei die besagte erste leitende Schicht (6) gemustert ist, um einen oder mehrere gemusterte Abschnitte (22, 23) zu bilden, die als Kontaktabschnitte für elektrische Schaltkreiselemente (15) in der unteren oder oberen Metallisierungsschicht (M1, M2) dienen, und/oder die selbst als die besagten elektrischen Schaltkreiselemente dienen.

4. Halbleitergehäuse nach Anspruch 3, wobei ein gemusterter Abschnitt (23) der ersten leitenden Schicht (6) einen Widerstand in der oberen Metallisierungsschicht (M2) bildet, und wobei ein Stapel eines Abschnitts der dielektrischen Schicht (7') und ein Abschnitt der oberen leitenden Schicht (8') auf der oberen Seite des besagten Widerstands vorhanden ist, wobei die besagte dielektrische Schicht (7') und der Abschnitt der oberen leitenden Schicht (8') das gleiche Material und die gleiche Dicke der besagten dielektrischen Schicht (7) und zweiten leitenden Schicht (8) des besagten Kondensators (50) aufweisen.

5. Halbleitergehäuse nach irgendeinem der Ansprüche 1 bis 4, wobei die zweite leitende Schicht (31) in der Ebene der Schicht von einer Ringstruktur (30) des gleichen Materials und der gleichen Dicke der besagtenzweiten leitenden Schicht (31) umgeben ist.

6. Halbleitergehäuse nach irgendeinem der Ansprüche 1 bis 5, wobei die erste und zweite Metallisierungsschicht (M1, M2) die Stromversorgungsschicht bzw. die Erdungsschicht des Interposer-Substrats ist, die eine oder mehrere integrierte Schaltkreisvorrichtungen trägt.

7. Halbleitergehäuse nach irgendeinem der Ansprüche 1 bis 6, wobei die besagte Boden- und/oder obere Platte mit Perforationen durch die gesamte Dicke der Platten ausgestattet ist, wobei die besagten Perforationen mit einem dielektrischen Material gefüllt sind.

8. Ein Verfahren zum Erzeugen eines Halbleitergehäuses nach irgendeinem der Ansprüche 1 bis 7, umfassend die folgenden Schritte:
- Erzeugen der unteren Metallisierungsschicht (M1) durch einen Damaszener-Prozess, wobei die besagte untere Metallisierungsschicht die Bodenplatte (4) umfasst,
- Ablegen eines Stapels der ersten leitenden Schicht (6), der dielektrischen Schicht (7) und der zweiten leitenden Schicht (8) auf und in Kontakt mit der unteren Metallisierungsschicht (M1),
- Mustern mindestens der zweiten Schicht (8) und der dielektrischen Schicht (7) zur Bildung eines Stapels (9) der ersten leitenden Schicht (6) oder eines Abschnitts davon, der dielektrischen Schicht (7) und der zweiten leitenden Schicht (8), die mindestens teilweise die besagte Bodenplatte (4) abdeckt,
- Erzeugen der oberen Metallisierungsschicht (M2) durch einen Damaszener-Prozess, wobei die besagte zweite Metallisierungsschicht die obere Platte (24) umfasst, die auf und in Kontakt mit der zweiten leitenden Schicht (8) des besagten Stapels (9) und des leitenden Wegs (25) ist.

9. Verfahren nach Anspruch 8, wobei der besagte Schritt des Musterns durchgeführt wird mit dem Zweck, einen Stapel der dielektrischen Schicht (7) und der zweiten leitenden Schicht (8) auf der ersten leitenden Schicht zu bilden, wobei die besagte erste leitende Schicht (6) nach dem besagten Schritt des Musterns intakt bleibt.

10. Verfahren nach Anspruch 9, wobei die besagte erste leitende Schicht (6) weiter in einem zweiten Schritt des Musterns gemustert wird.

11. Verfahren nach Anspruch 10, wobei während des besagten zweiten Schritt des Musterns der Abschnitt der besagten ersten leitenden Schicht (6) und der Abschnitt der zweiten leitenden Schicht (8) des besagten Stapels (9) gleichzeitig gemustert werden.

12. Verfahren nach Anspruch 10, wobei während des besagten zweiten Schritts des Musterns der Abschnitt der zweiten leitenden Schicht (8) des Stapels (9) gemustert wird, um eine Ringstruktur (30) um einen zentralen Abschnitt (31) der zweiten leitenden Schicht zu bilden.

## Revendications

1. Boîtier de dispositif semi-conducteur comprenant un ou plusieurs dispositif(s) semi-conducteur(s) et un substrat interposeur ; le substrat interposeur comprenant une pile (de couches) de métallisation ; le ou les dispositif(s) semiconducteur(s) étant couplé(s) électriquement à la pile de métallisation, ladite pile de métallisation comprenant une pluralité de couches de métallisation (interconnectées) reliées les unes aux autres, dans lequel un condensateur métal-isolant-métal (50) est formé entre deux desdites couches de métallisation, une couche inférieure (M1) et une couche supérieure (M2), lesdites couches étant directement adjacentes dans la pile de métallisation, dans lequel ledit condensateur comprend :
- au moins une partie d'une plaque inférieure (4) qui fait partie de la couche de métallisation inférieure (M1),
- au moins une partie d'une première couche conductrice (6) sur et en contact avec ladite plaque inférieure,
- une couche diélectrique (7) sur et en contact avec ladite première couche conductrice,
- une seconde couche conductrice (8, 31) sur et en contact avec ladite couche diélectrique,
- une plaque supérieure (24) qui est une première partie de la couche de métallisation supérieure, ladite plaque supérieure étant sur et en contact avec ladite seconde couche conductrice (8) et s'étendant verticalement de la seconde couche conductrice jusqu'à un niveau de surface supérieure de la couche de métallisation supérieure,
dans lequel la première couche conductrice (6) s'étend au-delà de la surface de la couche diélectrique (7) et de la seconde couche conductrice (8), formant ainsi une partie d'extension (21) qui s'étend latéralement au-delà d'une zone recouverte par la couche diélectrique et la seconde couche conductrice ; et dans lequel la pile de métallisation comprend en outre un trou d'interconnexion (25) qui forme une seconde partie de la couche de métallisation supérieure et est latéralement séparé de la première partie (24) de la couche de métallisation supérieure, le trou d'interconnexion conducteur (25) s'étendant verticalement de la partie d'extension (21) de la première couche conductrice jusqu'au niveau de surface supérieure de la couche de métallisation supérieure.

2. Boîtier semi-conducteur selon la revendication 1, dans lequel ladite première couche conductrice (6) est dessinée dans la zone située à l'extérieur de la zone recouverte par le condensateur métal-isolant-métal (50).

3. Boîtier semi-conducteur selon la revendication 1, dans lequel ladite première couche conductrice (6) est dessinée afin de former une ou plusieurs partie(s) dessinée(s) (22, 23) qui servent de parties de contact pour des éléments de circuit électrique (15) dans la couche de métallisation inférieure ou supérieure (M1, M2) et/ou qui servent elles-mêmes desdits éléments de circuit électrique.

4. Boîtier semi-conducteur selon la revendication 3, dans lequel une partie dessinée (23) de la première couche conductrice (6) forme une résistance dans la couche de métallisation supérieure (M2), et dans lequel une pile d'une partie de couche diélectrique (7') et d'une partie de couche conductrice supérieure (8') est présente sur le dessus de ladite résistance, ladite couche diélectrique (7') et ladite partie de couche conductrice supérieure (8') étant du même matériau et de la même épaisseur que ladite couche diélectrique (7) et la seconde couche conductrice (8) dudit condensateur (50).

5. Boîtier semi-conducteur selon l'une quelconque des revendications 1 à 4, dans lequel la seconde couche conductrice (31) est entourée sur le plan de la couche par une structure en anneau (30) du même matériau et de la même épaisseur que ladite seconde couche conductrice (31).

6. Boîtier semi-conducteur selon l'une quelconque des revendications 1 à 5, dans lequel lesdites première et seconde couches de métallisation (M1, M2) sont la couche d'alimentation électrique et la couche de terre, respectivement, du substrat interposeur qui porte un ou plusieurs dispositif(s) de circuit(s) intégré(s).

7. Boîtier semi-conducteur selon l'une quelconque des revendications 1 à 6, dans lequel ladite plaque inférieure et/ou supérieure est munie de perforations à travers l'épaisseur complète des plaques, lesdites perforations étant remplies avec un matériau diélectrique.

8. Procédé de fabrication d'un boîtier semi-conducteur selon l'une quelconque des revendications 1 à 7, comprenant les étapes consistant à :
- fabriquer la couche de métallisation inférieure (M1) à l'aide d'un processus de damasquinage, ladite couche de métallisation inférieure comprenant la plaque inférieure (4),
- déposer une pile avec la première couche conductrice (6), la couche diélectrique (7) et la seconde couche conductrice (8) sur et en contact avec ladite couche de métallisation inférieure (M1),
- graver au moins la seconde couche (8) et la couche diélectrique (7) afin de former une pile (9) avec la première couche conductrice (6) ou une partie de celle-ci, la couche diélectrique (7) et la seconde couche conductrice (8), qui recouvre au moins partiellement ladite plaque inférieure (4),
- fabriquer la couche de métallisation supérieure (M2) à l'aide d'un processus de damasquinage, ladite seconde couche de métallisation comprenant la plaque supérieure (24) qui est sur et en contact avec la seconde couche conductrice (8) de ladite pile (9) et du trou d'interconnexion (25).

9. Procédé selon la revendication 8, dans lequel ladite étape de gravure est exécutée afin de former une pile de la couche diélectrique (7) et de la seconde couche conductrice (8) sur le dessus de la première couche conductrice, ladite première couche conductrice (6) restant intacte après ladite étape de gravure.

10. Procédé selon la revendication 9, dans lequel ladite première couche conductrice (6) est en outre gravée lors d'une seconde étape de gravure.

11. Procédé selon la revendication 10, dans lequel, pendant ladite seconde étape de gravure, ladite première couche conductrice (6) et la seconde partie de couche conductrice (8) de ladite pile (9) sont gravées en même temps.

12. Procédé selon la revendication 10, dans lequel, pendant ladite seconde étape de gravure, la seconde partie de couche conductrice (8) de la pile (9) est gravée afin de former une structure en anneau (30) autour d'une partie centrale (31) de la seconde couche conductrice.
